# EUROPÄISCHE PATENTSCHRIFT

(11) **EP 0 793 859 B1**
(45) Veröffentlichungstag und Bekanntmachung des Hinweises auf die Patenterteilung: **11.09.2002**
(21) Anmeldenummer: 95941003.6
(22) Anmeldetag: 23.11.1995
(51) Int. Cl.: H01L 23/498, H01B 3/30, H05K 5/02, G01P 1/00

(54) **ZUM AUFNEHMEN VON ELEKTRONISCHEN UND/ODER MIKROMECHANISCHEN BAUTEILEN BESTIMMTES GEHÄUSE AUS EINEM KUNSTSTOFF, IN WELCHES LEITERBAHNEN HINEINFÜHREN**
PLASTIC HOUSING DESIGNED TO ACCOMMODATE ELECTRONIC AND/OR MICROMECHANICAL COMPONENTS AND INTO WHICH CONDUCTOR TRACKS PASS
BOITIER EN MATIERE PLASTIQUE DESTINE A RECEVOIR DES COMPOSANTS ELECTRONIQUES ET/OU MICROMECANIQUES, ET DANS LEQUEL PASSENT DES TRACES CONDUCTEURS

(30) Priorität: 25.11.1994 DE 9418940 U; 31.12.1994 DE 9420980 U
(43) Veröffentlichungstag der Anmeldung: 10.09.1997
(73) Patentinhaber: AMI Doduco GmbH, 75181 Pforzheim (DE)
(72) Erfinder: KASPAR, Franz, D-75223 Niefern (DE); KÜHNLE, Andreas, D-75433 Maulbronn (DE)
(74) Vertreter: Twelmeier, Ulrich, Dipl.Phys.
(86) Internationale Anmeldenummer: EP9504617
(87) Internationale Veröffentlichungsnummer: WO96017383

(56) Entgegenhaltungen:
- WO-A-92/20096
- DE-A- 1 816 998
- DE-A- 4 105 913
- DE-U- 9 415 696
- US-A- 4 079 511
- US-A- 4 406 993
- US-A- 5 152 057
- PATENT ABSTRACTS OF JAPAN vol. 16 no. 536 (P-1229) ,6.November 1992 & JP,A,04 204264 (MITSUBISHI ELECTRIC CORP. ) 24.Juni 1992,

## Beschreibung

Die Erfindung befaßt sich mit einem zum Aufnehmen von elektronischen und/oder mikromechanischen Bauteilen bestimmten Gehäuse aus einem thermoplastischen Kunststoff, in welches metallische Leiterbahnen hineinführen, die zu diesem Zweck in eine Wand des Gehäuses eingespritzt sind. Bei einigen Anwendungen müssen solche Gehäuse hermetisch dicht sein. Eine kritische Stelle für die Abdichtung des Gehäuses ist die Durchführung von Leiterbahnen durch eine Gehäusewand in das Gehäuse hinein. Solche Leiterbahnen werden häufig als Stanzgitter aus einem Metallband, z.B. aus einem mit Aluminium beschichteten Kupferband, vorgefertigt, in eine Spritzgießform eingelegt, in welcher ein Gehäuseteil gespritzt wird, und auf diese Weise teilweise mit Kunststoff umspritzt. Probleme ergeben sich daraus, daß Metalle und Kunststoffe sich im thermischen Ausdehnungskoeffizienten deutlich unterscheiden. Kupfer z.B. hat einen Ausdehnungskoeffizienten von 17 x 10⁻⁶/°K, thermoplastische Kunststoffe haben typisch einen Ausdehnungskoeffizienten zwischen 20 x 10⁻⁶ und 30 x 10⁻⁶/°K. Bei Wärmebelastungen des Gehäuses, die nicht nur unter bestimmten Einsatzbedingungen auftreten können, sondern bereits während der Fertigung, insbesondere beim Aushärten von Klebstoffen und beim Verlöten von Bauelementen mit den eingespritzten Leiterbahnen, bauen sich im Kunststoff mechanische Spannungen auf. Durch die thermische Beanspruchung schiebt sich der Kunststoff über die metallischen Leiterbahnen hinweg. Es kommt dabei teilweise zu einem Ablösen des Kunststoffs vom Metall, was meist nicht weiter schlimm ist, da der Spalt eng genug ist, um hinreichende Dichtigkeit zu gewährleisten. Es kommt jedoch auch vor, daß der Kunststoff quer zur Leiterbahn einreißt, wodurch Zutritte zu dem Spalt zwischen der Leiterbahn und dem Kunststoff geschaffen werden, die Undichtigkeiten zur Folge haben.

Es ist Stand der Technik, durch geeignete Materialauswahl den Unterschied in den Ausdehnungskoeffizienten zwischen Metall und Kunststoff möglichst klein zu halten sowie durch geeignete Form der Leiterbahnen die Spannungen zwischen ihnen und dem Kunststoff möglichst gering zu halten. Das führt jedoch nur teilweise zum Erfolg; einerseits sind die Materialien nicht frei wählbar, denn sie müssen ja noch weitere Forderungen hinsichtlich elektrischer Leitfähigkeit, Oberflächenbeschaffenheit, mechanischer Formstabilität, thermischer Formstabilität, Lösungsmittelbeständigkeit, Beständigkeit gegen Öle und Fette, Alterungsbeständigkeit und dergleichen erfüllen; andererseits haben thermoplastische Kunststoffe, die zur Erhöhung der mechanischen und thermischen Stabilität mit Glasfasern gefüllt sind, meist einen anisotropen Wärmeausdehnungskoeffizienten, so daß eine vollkommene Anpassung an den Wärmeausdehnungskoeffizienten der Leiterbahn ohnehin nicht möglich ist.

Die US 5,152,057 A offenbart Gehäuse aus einem PPS für integrierte Schaltungen, von welchen Leiterbahnen durch die Gehäusewand herausführen. in der US 5,152,057 A wird über Probleme mit der Dichtigkeit berichtet.

Die US 4,079,511 offenbart ebenfalls thermoplastische Gehäuse für integrierte Schaltungen, von welchen Leiterbahnen durch das Gehäuse nach außen führen. In diesem Fall wird die integrierte Schaltung durch Auffüllen des Gehäuses mit einem Silikon vor Feuchtigkeit geschützt.

Die DE 41 05 913 A1 offenbart Mischungen von Polyarylensulfiden (PAS), vorzugsweise Polyphenylensulfiden (PPS) mit Polymaleinimiden und gegebenenfalls weiteren Zusatzstoffen wie Glasfasern und Pigmenten; zwei angeführte Beispiele weisen eine Biegefestigkeit von 249 MPa bzw. 318 MPa auf.

Angesichts dieser Sachlage stellt sich die Aufgabe, eine Möglichkeit aufzuzeigen, auf welche Weise man die Dichtigkeit solcher Gehäuse verbessem kann.

Diese Aufgabe wird gelöst durch die Verwendung eines thermoplastischen Kunststoffs mit einer Biegefestigkeit von wenigstens 200 MPa zum Herstellen eines hermetisch dichten Gehäuses zum Aufnehmen von elektronischen und/oder mikromechanischen Bauteilen, in welches metallische Leiterbahnen hineinführen, die zu diesem Zweck in eine Wand des Gehäuses eingespritzt werden. Überraschenderweise hat es sich gezeigt, daß man die Neigung zur Bildung von Rissen, welcher quer zu den Leiterbahnen in der Gehäusewand verlaufen, verringern kann, wenn man den thermoplastischen Kunststoff, mit welchem die Leiterbahnen umspritzt werden, danach auswählt, daß er eine möglichst hohe Biegefestigkeit hat. Erfindungsgemäß wird deshalb vorgeschlagen, einen thermoplastischen Kunststoff auszuwählen, dessen Biegefestigkeit wenigstens 200 MPa, vorzugsweise mehr als 250 MPa, beträgt. Solche hohen Werte für die Biegefestigkeit findet man insbesondere bei hochtemperaturfesten Thermoplasten wie PPS. Thermoplastische Hartkunststoffe auf der Basis von PPS sind deshalb bevorzugt. Als besonders geeignet hat sich glasgefülltes PPS erwiesen, welches von der Firma PHILLIPS unter der Handelsbezeichnung RYTON R4-XT (TM) erhältlich ist. Dieser Werkstoff zeichnet sich durch eine Biegefestigkeit von 265 MPa aus, bestimmt nach ASTM D695-69. Besonders bevorzugt sind mit Glasfasern gefüllte Kunststoffe, in denen die Glasfasern möglichst isotrop verteilt sind, um eine Anisotropie des Wärmeausdehnungskoeffizienten zu vermeiden und gleichzeitig eine hohe Biegefestigkeit zu erreichen.
Ein Vorteil der Erfindung besteht darin, daß man bei Auswahl eines thermoplastischen Kunststoffs mit hoher Biegefestigkeit sogar darauf verzichten kann, den thermischen Ausdehnungskoeffizienten des Kunststoffs an jenen der metallischen Leiterbahn anzupassen, und trotzdem dicht eingespritzte Leiterbahnen gewährleisten kann.

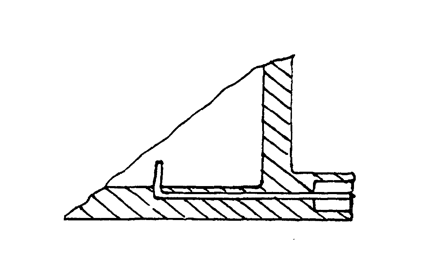

Die beigefügte Zeichnung zeigt im Schnitt einen Teil einer Gehäusewand aus einem formstabilen Kunststoff, in welchen eine Leiterbahn eingebettet ist, welche bereichsweise mit Kunststoff in einer Schichtdicke von nur 0,4 mm umspritzt ist. Bei Verwendung eines Kunststoffs mit einer Biegefestigkeit von 190 MPa konnten nach dem Auflöten von Bauelementen und nach dem Versiegeln des Gehäuses noch Undichtigkeiten infolge von Mikrorissen in der 0,4 mm dicken Kunststoffschicht beobachtet werden. Bei Einsatz eines glasgefültten PPS-Kunststoffs mit einer Biegefestigkeit von 265 MPa wurden solche Mikrorisse nicht mehr beobachtet. Die Untersuchungen wurden durchgeführt an ölgefüllten Gehäusen für einen mikromechanischen Beschleunigungssensor.

PPS = Polyphenylensulfid

## Patentansprüche

1. Die Verwendung eines thermoplastischen Kunststoffes zum Herstellen eines hermetisch dichten Gehäuses zum Aufnehmen von elektronischen und/oder mikromechanischen Bauteilen, in welches metallische Leiterbahnen hineinführen, die zu diesem Zweck in eine Wand des Gehäuses eingespritzt werden, **dadurch gekennzeichnet, daß** ein Kunststoff mit einer Biegefestigkeit von wenigstens 200 MPa verwendet wird.

2. Die Verwendung nach Anspruch 1, **dadurch gekennzeichnet, daß** ein Kunststoff mit einer Biegefestigkeit von wenigstens 250 MPa verwendet wird.

3. Die Verwendung nach Anspruch 1 oder 2, **dadurch gekennzeichnet, daß** als Kunststoff ein PPS verwendet wird.

4. Die Verwendung nach Anspruch 3, **dadurch gekennzeichnet, daß** als Kunststoff ein mit Glasfaser gefülltes PPS verwendet wird.

5. Die Verwendung nach Anspruch 3 oder 4, **dadurch gekennzeichnet, daß** ein Kunststoff auf PPS-Basis mit einer Biegefestigkeit von 265 MPa verwendet wird.

6. Die Verwendung nach Anspruch 4, **dadurch gekennzeichnet, daß** ein Kunststoff verwendet wird, in welchem die Verteilung der Glasfasern keine oder nur eine geringe Anisotropie aufweist.

## Claims

1. Use of a thermoplastic synthetic material for manufacturing a hermetically sealed housing to accommodate electronic and/or micromechanical components into which lead metallic leads which for this purpose are embedded in a wall of the housing by injection moulding,
**characterised in that** a synthetic material with a flexural strength of at least 200 MPa is used.

2. A housing according to claim 1 in which the synthetic material has a flexural strength of at least 250 MPa.

3. A housing as claimed in claim 1 or 2 in which the synthetic material is a PPS.

4. A housing as claimed in claim 3 in which the synthetic material is a glass fiber filled PPS.

5. A housing as claimed in claim 3 or 4 in which the PPS-based synthetic material exhibits a flexural strength of 265 MPa.

6. A housing as claimed in claim 4 in which the distribution of the glass fibers in the synthetic material is isotropic or does exhibit merely a slight anisotropy.

## Revendications

1. Utilisation d'une matière synthétique thermoplastique pour la fabrication d'un boîtier à fermeture hermétique destiné à la réception de composants électroniques et/ou micromécaniques, boîtier dans lequel on insère des pistes conductives métalliques qui, à cet effet sont moulées par injection dans une paroi du boîtier, **caractérisée en ce qu'**on utilise une matière synthétique qui possède une résistance à la flexion minimale de 200 MPa.

2. Utilisation selon la revendication 1, **caractérisée en ce qu'**on utilise une matière synthétique qui possède une résistance à la flexion minimale de 250 MPa.

3. Utilisation selon la revendication 1 ou 2, **caractérisée en ce qu'**on utilise, à titre de matière synthétique, un PPS.

4. Utilisation selon la revendication 3, **caractérisée en ce qu'**on utilise, à titre de matière synthétique, un PAS contenant des fibres de verre à titre de matière de charge.

5. Utilisation selon la revendication 3 ou 4, **caractérisée en ce qu'**on utilise une matière synthétique à base de PPS possédant une résistance à la flexion de 265 MPa.

6. Utilisation selon la revendication 4, **caractérisée en ce qu'**on utilise une matière synthétique dans laquelle la distribution des fibres de verre ne présente aucune anisotropie ou encore une anisotropie seulement minime.
